# EUROPEAN PATENT SPECIFICATION

(11) **EP 0 579 300 B1**
(45) Date of publication and mention of the grant of the patent: **21.01.1998**
(21) Application number: 93201724.7
(22) Date of filing: 16.06.1993
(51) Int. Cl.: G01R 33/58, G01R 33/36

(54) **Phantom for simulating the electric loading in a magnetic resonance apparatus**
Phantom zum Simulieren der elektrischen Belastung in einem magnetischen Resonanzapparat
Fantôme de simulation de la charge électrique dans un appareil à résonance magnétique

(30) Priority: 22.06.1992 EP 92201816
(43) Date of publication of application: 19.01.1994
(73) Proprietor: Philips Electronics N.V., 5621 BA Eindhoven (NL)
(72) Inventor: Van Heelsbergen, Teunis Robert, NL-5656 AA Einhoven (NL); Tinus, Antonius Matheus Carolus, NL-5656 AA Einhoven (NL)
(74) Representative: Bakker, Hendrik

(56) References cited:
- US-A- 4 719 406
- US-A- 4 791 372
- MEDICAL PHYSICS. vol. 11, no. 2 , 1 March 1984 , NEW YORK US pages 180 - 185 W.A. EDELSTEIN ET AL. 'A SIGNAL-TO-NOISE CALIBRATION PROCEDURE FOR NMR IMAGING SYSTEMS'
- MAGNETIC RESONANCE IN MEDICINE. vol. 16, no. 2 , 1 November 1990 , DULUTH,MN US pages 294 - 302 T.J. LAWRY ET AL. 'COMPUTER MODELING OF SURFACE COIL SENSITIVITY'
- THE BRITISH JOURNAL OF RADIOLOGY vol. 59, no. 706 , 1 October 1986 , LONDON,GB pages 1031 - 1034 S.J. JENNINGS ET AL. 'SIMULATION OF PATIENT LOADING IN NUCLEAR MAGNETIC RESONANCE IMAGING THROUGH THE USE OF INDUCTIVE DAMPING LOOPS'

## Description

The invention relates to a phantom for simulating the electric load constituted by an object to be examined for an RF coil of a magnetic resonance apparatus, comprising a loop which can be inductively coupled to the RF coil and in which a predetermined electric resistance is included.

Examples of such a phantom are described in The British Journal of Radiology, **59**, pages 1031-1034. One feasible embodiment of the phantom is a ringshaped vessel filled with, for example a saline solution. It is a drawback of such a container that it is bulky, heavy and vulnerable. Another solution disclosed in the cited article consists of a closed loop which can be inductively coupled to the RF coil and which comprises, for example, a coil, a resistor and a capacitor. This solution is comparatively expensive, the more so because the resistor and the capacitor should preferably be variable so as to enable adaptation of the phantom to various circumstances.

It is an object of the invention to provide a phantom of the kind set forth which is inexpensive and light and has a simple construction. To achieve this, the phantom in accordance with the invention is characterized in that the loop includes a member whose shape corresponds substantially to the shape of the RF coil and which is made of a solid material, the specific electric resistance and the thickness of the material being chosen so that the square resistance measured on the surface of the member is between predetermined limits, at least one strip-shaped additional element made of a solid material having a predetermined specific resistance being arranged on the surface of the member in order to achieve a local decrease of the effective square resistance.

The square resistance is the electric resistance measured between two oppositely situated sides of a square part of a surface. This resistance is independent of the dimensions of the square. When the member is positioned in the vicinity of an RF coil, electric eddy currents can be induced in the wall of the body. As a result, the RF coil is loaded by a resistance whose value depends on said square resistance of the wall of the member.

The member is formed so that the square resistance is initially too high, so that the loading of the RF coil is too small. The effective square resistance is adjusted to the desired value by application of one or more of the additional elements.

The member may be formed as a self-supporting member of a material having a suitable specific resistance. However, the member is preferably formed as a layer of an electric resistive material provided on an electrically insulating support having a suitably shaped surface. The support may be made of a suitable synthetic material, for example, PVC, and the resistive layer may be formed, for example by application of a layer of electrically conductive lacquer. Lacquers having a given specific resistance are commercially available. When such a lacquer is provided in a given thickness on the support, a member having a predetermined square resistance is obtained. This resistance may be chosen so that the loading of the RF coil is too high. In that case the load can be reduced to the desired value by removing material from the wall of the support, for example by scratching off a part of the layer of lacquer or by dissolving it by means of a suitable solvent.

When the RF coil is a surface coil, the member is preferably shaped as a flat plate. A phantom which is particularly suitable for cylindrical RF coils is characterized in that the member is shaped as a hollow cylinder, the additional elements being shaped as a ring having a circumference which corresponds substantially to that of the cylinder and a height which is less than that of the cylinder. Each application of an additional element then reduces the effective square resistance of an annular part of the cylinder wall by an amount which is dependent on the resistance of the relevant additional element. A further embodiment is characterized in that each additional element is formed as a layer of an electric resistive material provided on a strip-shaped, flexible support of an electrically insulating material. The resistance of the additional element can then be readily changed by cutting the strip to a desired width prior to its application to the surface of the member.

These and other aspects of the invention will be described in detail hereinafter with reference to the drawing.
Fig. 1 shows a circuit diagram of an RF coil of a magnetic resonance apparatus which is inductively coupled to a phantom in accordance with the invention,
Fig. 2 is a perspective view of a phantom in accordance with the invention, the additional element being not represented,
Fig. 3 is an axial view of a part of the phantom shown in Fig. 2,
Fig. 4 is a partial view of a part of the phantom in accordance with the invention, the additional element being represented, and
Fig. 5 is an axial view of the phantom according to Fig. 4.

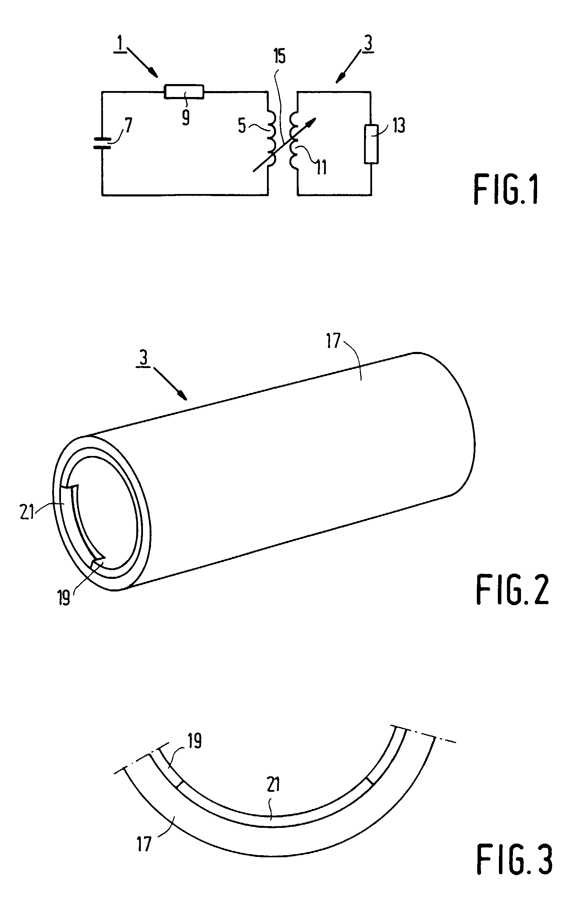

Fig. 1 shows an electric equivalent diagram of an RF coil 1 which is inductively coupled to a phantom 3. The RF coil 1 is equivalent to a loop consisting of a series connection of a coil 5, a capacitor 7 and a resistor 9 which represents the electric resistance of the conductors constituting the RF coil. The phantom 3 is equivalent to a loop comprising a coil 11 and a resistor 13. The phantom 3 is arranged in the vicinity of the RF coil 1 (in the case of a cylindrical RF coil, for example in a space enclosed by the RF coil), so that the coils 5 and 11 are inductively coupled to one another as denoted by an arrow 15. As a result of this coupling, the resistance 9 in the RF coil 1 is increased by an amount which is dependent on the value of the resistance 13. The same effect occurs when the RF coil is moved to the vicinity of an object to be examined in which eddy currents can occur, for example a patient. As a result, the quality of the loop representing the RF coil is reduced.

Fig. 2 is a perspective view of the phantom 3. It is formed by a support 17 in the form of a hollow cylinder of a electrically insulating material, for example PVC, the inner surface of which is covered by a layer of an electric resistive material 19 which, evidently, is also shaped as a hollow cylinder, thus constituting a member having mainly the same shape as the RF coil. This layer can be provided, for example, by vapour deposition or silk screening. A very simple and effective method for applying a layer 19, however, is to cover the inner surface with a layer of lacquer which contains material of a predetermined specific electric resistance and which forms a layer of solid resistive material after drying. Lacquers of this kind are commercially available. An example in this respect is Electrodag 5513 marketed by Acheson.

The electric square resistance measured on the cylinder surface depends not only on the composition of the layer 19 but also on the dimensions of the support and the thickness of the layer. An easy method of achieving exactly the desired resistance is to apply a layer 19 which is slightly too thick, and to remove a part of the layer at a later stage. This part is denoted by the reference 21 in Fig. 2. Removal can be effected, for example by scratching off the lacquer locally or by dissolving it by means of a suitable solvent. Fig. 3 is a partial axial view, at an increased scale, of the left-hand end of the phantom shown in Fig. 2. This Figure clearly shows the layer 19 with the removed part 21.

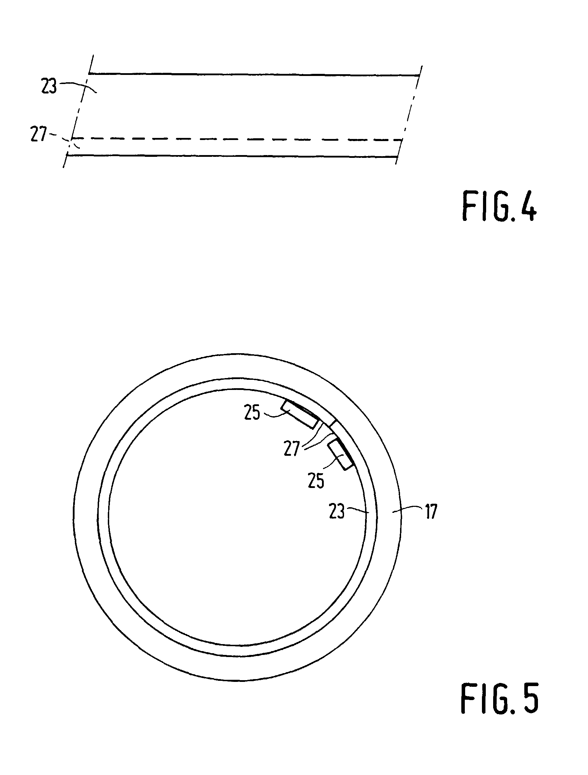

Another method of adjusting the resistance of the phantom to a desired value is to provide a layer 19 which is slightly too thin, after which an additional element is arranged on the cylinder surface in order to achieve a local decrease of the effective square resistance. Fig. 4 shows such an embodiment. The additional element 23 thereof consists of a flexible strip made of a solid material having a predetermined specific resistance. This strip may consist entirely of resistive material, but is preferably formed as a layer of a resistive material provided on a flexible, strip-shaped substrate of an electrically insulating material. This construction is, therefore, analogous to the construction of the phantom 3 described with reference to Fig. 2. The additional element 23 may have the same square resistance as the layer 19. However, it is alternatively possible to choose a material having a very low specific resistance for the additional element, for example copper. The additional element 23 is intended to be mounted on the surface of the resistive layer 19. Depending on the square resistance of the additional element 23, the eddy currents generated in the relevant part of the layer 19 are then increased by a given amount (*i.e*. the loop quality Q of the phantom is decreased), so that the loading of the RF coil increases. Q is adjusted to the desired value as follows. First, the Q of the cylinder is measured without additional elements. This Q is always too high. Subsequently, a strip which brings the Q to approximately the desired value is chosen from a stock of strips having different square resistances. Generally speaking, the Q will then be slightly too low. By cutting the strip to the correct width or length, an additional element can be formed whereby the desired value of Q is obtained exactly. To this end, for example an edge strip 27 is cut off.

The additional element 23 is provided on the layer 19 so that it extends over a part of the cylinder circumference, analogous to the part 21 shown in the Figs. 2 and 3. However, the length of the short-circuit element is preferably so that the additional element extends over the entire circumference of the cylinder, so that the loading of the RF coil is uniformly distributed over the circumference. After mounting on the support 17 with the layer 19, the additional element 23 is then shaped as a closed ring having a circumference which corresponds substantially to that of the cylinder and a height (dimension in the axial direction) which is smaller than that of the cylinder. This is shown in an end view in Fig. 5, which is analogous to that of Fig. 3. In order to ensure easy mounting of the additional element 23 on the support 17, the support is preferably provided with fixing means, for example in the form of fingers 25 which extend in the axial direction, and underneath the free ends of which the additional element 23 can be slid.

Because the resistance of the phantom 3 can be very simply adjusted to a desired value in the manners described above, no severe requirements are imposed as regards the accuracy of deposition of the layer 19. The phantom can also be manufactured in a very simple and inexpensive manner. Evidently, the shape and the dimensions of the body can be adapted to any requirement. Instead of the straight circular cylinder shown in the Figures, any other cylindrical shape or, for example the shape of a flat or curved plate can be chosen, depending on the shape of the RF coil for which the phantom is intended.

## Claims

1. A phantom for simulating the electric load constituted by an object to be examined for an RF coil (1) of a magnetic resonance apparatus, comprising a loop (3) which can be conductively coupled to the RF coil (1) and in which a predetermined electric resistance is included, characterized in that the loop (3) includes a member (19) whose shape corresponds substantially to the shape of the RF coil (1) and which is made of a solid material, the specific electric resistance and the thickness of the material being chosen so that the square resistance measured on the surface of the member is between predetermined limits, at least one strip-shaped additional element (23) made of a solid material having a predetermined specific resistance being arranged on the surface of the member in order to achieve a local decrease of the effective square resistance.

2. A phantom as claimed in Claim 1, characterized in that the member (19) is formed as a layer of an electric resistive material provided on an electrically insulating support (17) having a suitably shaped surface.

3. A phantom as claimed in Claim 1 or 2, characterized in that the member (19) is shaped as a hollow cylinder, the additional elements (23) being shaped as a ring having a circumference which corresponds substantially to that of the cylinder and a height which is less than that of the cylinder.

4. A phantom as claimed in Claim 3, characterized in that each additional element (23) is formed as a layer of an electric resistive material provided on a strip-shaped, flexible support of an electrically insulating material.

## Patentansprüche

1. Phantom zum Simulieren der elektrischen Last, die ein zu untersuchendes Objekt für eine HF-Spule (1) eines Kernresonanzgeräts darstellt, mit einer Schleife (3), die mit der HF-Spule (1) induktiv verbunden werden kann und in der ein zuvor bestimmter elektrischer Widerstand enthalten ist, dadurch gekennzeichnet, daß die Schleife (3) einen Körper (19) enthält, dessen Form im wesentlichen der Form der HF-Spule (1) entspricht und der aus einem festen Stoff hergestellt ist, wobei der spezifische elektrische Widerstand und die Dicke des Materials so gewählt sind, daß der auf der Oberfläche des Körpers gemessene Flächenwiderstand zwischen zuvor bestimmten Grenzen liegt, wobei zumindest ein streifenförmiges zusätzliches Element (23) aus einem festen Stoff, der einen zuvor bestimmten spezifischen Widerstand hat, auf der Oberfläche des Körpers angeordnet ist, um eine örtliche Abnahme des effektiven Flächenwiderstandes zu erhalten.

2. Phantom nach Anspruch 1, dadurch gekennzeichnet, daß der Körper (19) als Schicht aus einem elektrischen Widerstandsmaterial gebildet ist, die auf einem elektrisch isolierenden Träger (17) mit geeignet geformter Oberfläche angebracht ist.

3. Phantom nach Anspruch 1 oder 2, dadurch gekennzeichnet, daß der Körper (19) als Hohlzylinder geformt ist, wobei das zusätzliche Elements (23) als Ring mit einem Umfang geformt ist, der nahezu dem des Zylinders entspricht, und mit einer Höhe, die kleiner als die des Zylinders ist.

4. Phantom nach Anspruch 3, dadurch gekennzeichnet, daß jedes zusätzliche Element (23) als Schicht aus elektrischem Widerstandsmaterial gebildet ist, die auf einem streifenförmigen, flexiblen Träger aus elektrisch isolierendem Material angebracht ist.

## Revendications

1. Fantôme pour simuler la charge électrique constituée par un objet à examiner pour une bobine radiofréquence (1) d'un appareil à résonance magnétique, comprenant une boucle (3) qui peut être couplée par induction à la bobine radiofréquence (1) et dans laquelle une résistance électrique prédéterminée est incluse, caractérisé en ce que la boucle (3) comprend un organe (19) dont la forme correspond sensiblement à la forme de la bobine radiofréquence (1) et qui est fait d'une matière solide, la résistance électrique spécifique et l'épaisseur de la matière étant choisies de façon que la résistance par carré mesurée sur la surface de l'organe se situe entre des limites prédéterminées, au moins un élément supplémentaire (23) en forme de ruban fait d'une matière solide ayant une résistance spécifique prédéterminée étant agencé à la surface de l'organe pour réaliser une baisse locale de la résistance par carré effective.

2. Fantôme suivant la revendication 1, caractérisé en ce que l'organe (19) est constitué sous la forme d'une couche d'une matière résistive électrique appliquée sur un support isolant électrique (17) ayant une surface convenablement conformée.

3. Fantôme suivant la revendication 1 ou 2, caractérisé en ce que l'organe (19) est constitué sous la forme d'un cylindre creux, les éléments supplémentaires (23) étant façonnés sous la forme d'une bague ayant une circonférence qui correspond sensiblement à celle du cylindre et une hauteur qui est inférieure à celle du cylindre.

4. Fantôme suivant la revendication 3, caractérisé en ce que chaque élément supplémentaire (23) est constitué sous la forme d'une couche d'une matière résistive électrique appliquée sur un support flexible en forme de bande d'une matière électriquement isolante.
